# EUROPEAN PATENT APPLICATION

(11) **EP 4 679 962 A1**
(43) Date of publication of application: **14.01.2026**
(21) Application number: 24189803.0
(22) Date of filing: 19.07.2024
(51) Int. Cl.: H05K 9/00

(54) **SHIELDING COMBINING PRESS-FIT WITH SURFACE MOUNT COMPRESSION**

(30) Priority: 09.07.2024 US 202463668833 P
(71) Applicant: Aptiv Technologies AG, 8200 Schaffhausen (CH)
(72) Inventor: DROESBEKE, Gert, 8200 Schaffhausen (CH); HACKBARTH, Daniel, 8200 Schaffhausen (CH); DANCISON, Phil M., 8200 Schaffhausen (CH)
(74) Representative: Bardehle Pagenberg Partnerschaft mbB Patentanwälte Rechtsanwälte

(57) **Abstract**

The present disclosure mainly relates to electromagnetic compatibility (EMC). An EMC shield (100) for providing electromagnetic compatibility of electronic components is provided. The EMC shield comprises at least one wall (102) comprises an interface portion (104). The interface portion comprises at least one coplanar edge (106A-D) of the wall. The EMC shield further comprises at least one mounting means (108A-B) adapted for mounting the EMC shield to a printed circuit board (PCB) such that, when the EMC shield is mounted to the PCB, the interface portion is substantially parallel to the PCB. The EMC shield (100) further comprises at least one contact means (112) different from the mounting mean(s). The contact mean(s) are integrated with the wall and at least partially extending outwards the interface portion (104) in a mounting direction of the EMC shield to the PCB. The contact means are adapted for providing, when the EMC shield is mounted to the PCB, a contact pressure between the contact means and the PCB along the mounting direction.

## Description

### 1. Field of the invention

The present disclosure mainly relates to electromagnetic compatibility (EMC). More specifically, an EMC shield for providing electromagnetic compatibility of electronic components is disclosed.

### 2. Prior art

Commonly, electric and/or magnetic fields generated by electronic components may be required to stay confined within a restricted space surrounding such components. Also, such fields may be required not to enter the electronic components from outside. Generally, electronic components comprise active components such as integrated circuits, discrete transistors, or the like, and passive components such as coils, cables, connectors, or the like. The rationale for the above reflected requirements includes avoiding mutual interference among electronic components/devices/units and/or ensuring compliance with regulatory (or customer) specifications. In general, various measures are known to facilitate electromagnetic compatibility (EMC) and limit electromagnetic interference (EMI). These measures include shielding electric and/or magnetic fields which aims at improving EMC/EMI properties. Shielding may be generally used with any electronic component being exposed to and/or generating high emissions of electromagnetic radiation. Shielding measures include placing electronic components at least partially within a shield which is formed from e.g., a piece of sheet metal.

In the field of communications, for example, internal communications within a vehicle, steadily increasing number of functions/features (e.g., autonomous driving) results in continuously growing demand for transferring data represented by electromagnetic signals. The increasing amount of data leads to increase in frequencies used for transferring data and, as a consequence, to decrease in wavelengths carrying data (since a wavelength is inversely proportional to a frequency). As a result, a maximum gap size allowed in the shielding generally becomes smaller in order for the shield to remain EMC/EMI compliant.

Ensuring a limited gap size is particularly challenging in the space immediately above the top metal layer of a printed circuit board (PCB). Even if reflow soldering is applied to obtain a non-interrupted connection between the top metal layer and the shield of an electronic component (such as the shield of a connector), certain gaps may be required to be left due to various considerations. For example, such gaps may be required for controlled distribution of solder paste (without solder balls or solder bridges after solder reflow). Further, for example, such gaps may be required for outgassing during the solder reflow process in order not to lift the electronic component. This is because typically about 50 % of the solder paste is alcohol which vaporizes during the reflowing.

Furthermore, for a variety of reasons, press-fit mounting is often a preferred technique for mounting certain electronic components (such as the shield of a connector and/or the connector itself) to the PCB. For instance, the press-fit mounting generally provides the lowest total applied cost. Moreover, with regard to the assembling process of the PCB, the use of press-fit mounting typically conveniently separates mounting of the connector/shield (which uses the press-fit mounting) from mounting other components on the PCB. As a result, tiny semiconductors and other surface-mounted devices (SMD) may be assembled to the PCB without compromises and inefficiencies imposed by the presence on the PCB of bulky components (such as connectors/shields). In the above approach, the bulky components may be press-fitted onto the PCB after all other components have been reflow-soldered into the PCB.

On the other hand, however, press-fit mounting requires a hole to be drilled (or milled) though the PCB. A large number of such holes is generally undesirable. This is because, the less such holes are present, the more PCB surface remains available to place components, the more space/options remain available to route traces in copper layers of the PCB and the better cost/operation efficiency of the PCB manufacturing process (due to less cycle time, less copper consumption to metalize the holes, less down time to replace worn out or broken drills, etc.) is achieved. Finally for the PCB to still have some strength and to be able to drill the holes with sufficient precision. a certain minimum of PCB material is to be maintain between the hole and the PCB edge or between successive holes.

In view of the above reflected background, the object of the presently disclosed subject matter is to provide an enhanced EMC shield for providing electromagnetic compatibility of electronic components which at least partially overcomes disadvantages attributable to prior art EMC shields and to have signal contacts suitable for higher data-transmissions thanks.

### 3. Summary of the invention

The above-mentioned object is realized by an EMC shield according to claim 1 and an electrical connector system according to claim 13.

Particularly, the above-mentioned object is realized by an EMC shield for providing electromagnetic compatibility of electronic components. The EMC shield comprises at least one wall (e.g., formed from a single sheet metal). The wall comprises an interface portion (e.g., a plane for being directly or indirectly attached to a printed circuit board (PCB)). The interface portion comprises (is defined by) a plurality of coplanar edges of the wall. Furthermore, the EMC shield comprises a plurality of mounting means (e.g., press-fit means adapted for insertion into the PCB) adapted for mounting the EMC shield to the PCB. The mounting means are adapted for mounting the EMC shield to the PCB such that, when the EMC shield is mounted to the PCB, the interface portion is substantially parallel (e.g., parallel within tolerances typically appliable in the art) to the PCB. The EMC shield comprises furthermore at least one contact means which is different from the above-mentioned mounting means. The contact means is integrated with (e.g., formed within, formed as a part, or the like) the wall. The contact means at least partially extends outwards the interface portion in a mounting direction of the EMC shield to the PCB. The contact means is adapted for providing, when the EMC shield is mounted to the PCB, a contact pressure between the contact means and the PCB along the mounting direction. In other words, the contact pressure is provided along a normal direction of the PCB. As a result, due to the contact pressure, the EMC shield advantageously reduces a gap size in the shielding and thereby enhances EMC/EMI properties since the contact means is positioned nearby (or in a direct electrical contact with) a top metal layer of the PCB without additional mounting features (e.g., press-fit means, soldering, or the like). In other words, the claimed subject matter may advantageously take advantage of the holding (retention) force provided by the mounting means while reducing the number of mounting means and still restraining the maximum gap size between the successive contact and/or mounting means and the top layer of the PCB by providing a normal force (and hence a contact pressure) onto the contact means besides the one already present in the mounting means.

In an aspect of the present disclosure, the contact pressure suffices (e.g., is designed to be just high enough under worst case conditions, not to stress & bow-out the PCB more as absolutely needed) to provide a gastight contact between the contact means and the top metal layer of the PCB. As a result, a gap size in the shielding may be advantageously further reduced. The gastight contact is preferably achieved by a cold weld between the contact means and the top metal layer of the PCB. As a result, the direct electric contact between the contact means and the top metal layer of the PCB may be advantageously more robust in terms of mechanical design and/or EMC/EMI performance.

In a further aspect of the present disclosure, the contact means comprises a resilient means. The resilient means preferably comprises at least one of a single ended contact beam, a double ended contact bow, an eye-of-the-needle shape, an H-shape/bow-tie shape or a bend castellation, and preferably wherein the bend castellation comprises a material reduction at an inside bend radius. Such bend castellations could furthermore have angled separations / stamped slots between them and be bend as such that hereby 2 shielding walls are positioned between the inside and the outside of the EMC shield, because to which an extra EMC labyrinth is created as most of these separations are now at least partially cover by metal of the shielding either in front or behind it. In other aspects of the present disclosure, the contact means comprises a non-resilient means. The non-resilient means preferably comprises at least one of a sharp castellation, a curved castellation, a rounded castellation, a flat area or a coined area (a line contact).

As a result, the shape of a contact means may be advantageously selected taking into account the amount of a holding (retention) force provided by the mounting means, the size of an allowable gap size for EMC/EMI purposes, the degree of resilience attributable to the shape and/or technological aspects of manufacturing the shape, for example, by stamping. In a non-limiting example, the bend castellation with a material reduction at the inside bend radius may advantageously enable a more compact design and/or less long slots besides the castellations and/or improve coplanarity across a sequence of castellations. In another non-limiting example, the sharp castellation may advantageously cut (bite) into the top metal layer of the PCB thereby creating an EMC labyrinth.

In a further aspect of the present disclosure, the at least one contact means comprises at least two contact means selected from one, two or more resilient means and/or one, two or more non-resilient means. As a result, reduction in a gap size in the shielding may be advantageously further optimized.

In a further aspect of the present disclosure, the wall and the contact means are formed from a single sheet metal, preferably, by stamping. As a result, the EMC shield may be advantageously manufactured regarding optimizing complexity and costs.

In a further aspect of the present disclosure, the wall and the contact means have substantially the same (e.g., within tolerances typically appliable in the art) thickness. As a result, complexity and costs of manufacturing may be advantageously reduced. In another aspect of the present disclosure, the contact means are thinner than the wall. As a result, the contact means may be advantageously more compact.

In a further aspect of the present disclosure, the contact means comprises a formed section. As a result, the contact means may be advantageously more compact and/or material may be advantageously displaced beyond the material thickness. In another aspect of the present disclosure, the contact means is located behind an overlapping section of the wall. As a result, colliding (e.g., hooking) of the contact means (e.g., the single ended contact beam) with another element may be advantageously prevented. In yet another aspect of the present disclosure, the contact means is located behind an insulator and/or a housing.

In a further aspect of the present disclosure, each of the plurality of mounting means is adapted for a press-fit insertion into the PCB. As a result, holding (retention) force may be advantageously provided by the mounting means.

Further particularly, the above-mentioned object is realized by an electrical connector system. The electrical connector system comprises a housing, a plurality of electrical contact elements arranged in the housing and the above-described EMC shield. The electrical connector system preferably comprises a further EMC shield (i.e., a second EMC shield). The above-described EMC shield (i.e., a first EMC shield) is connected onto the second EMC shield. As a result, the above-described EMC shield may be advantageously manufactured from a separate sheet metal and may be attached, for example, to another EMC shield (e.g., a shield of any existing design).

In a further aspect of the present disclosure, the second EMC shield is made of a sheet metal, a die-cast, a sintered metal, a metal injection molding, a 3D-printing, a metalized plastic, or a conductive plastic. In yet a further aspect of the present disclosure, the EMC shield is connected onto the second EMC shield by riveting, laser-welding, resistance welding, ultrasonic welding, soldering or gluing. As a result, robust and cost-efficient shielding may be advantageously provided.

### 4. Brief description of the drawings

In the following, various aspects of the disclosed subject matter are described in detail with reference to the accompanying figures, in which:
- Fig. 1: shows schematically an embodiment of an EMC shield;
- Fig. 2A: shows schematically an embodiment of an EMC shield with a resilient contact means;
- Fig. 2B: shows schematically an embodiment of an EMC shield with non-resilient contact means;
- Fig. 3: shows a portion of an embodiment of an EMC shield with various contact means in a two-dimensional view;
- Fig. 4A/B: show schematically another embodiment of an EMC shield in a 3D-view and a front view;
- Fig. 5A/B: show schematically another embodiment of an EMC shield in a 3D-view and a front view;
- Fig. 6A/B: show schematically another embodiment of an EMC shield in a 3D-view and a front view; and
- Fig. 7A/B: show schematically another embodiment of an EMC shield in a 3D-view and a front view.

### 5. Detailed description

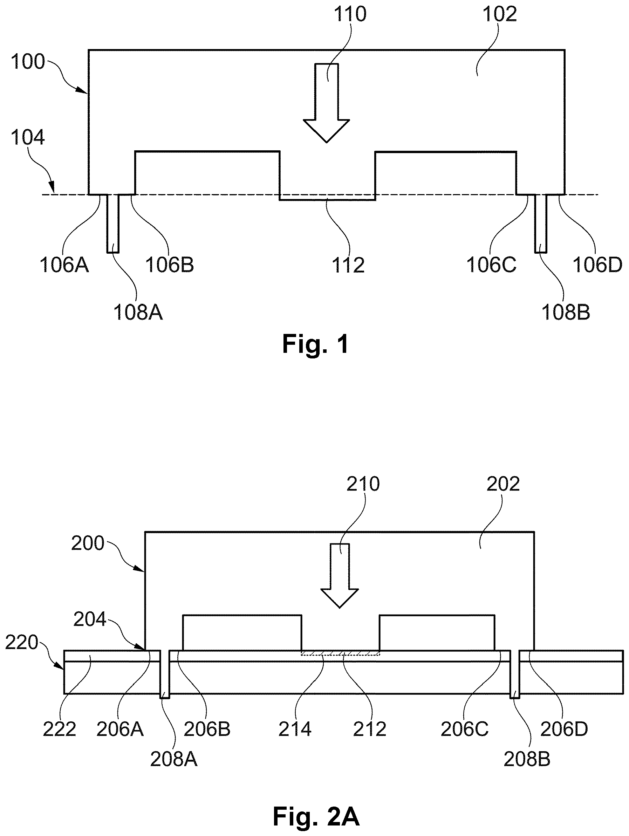

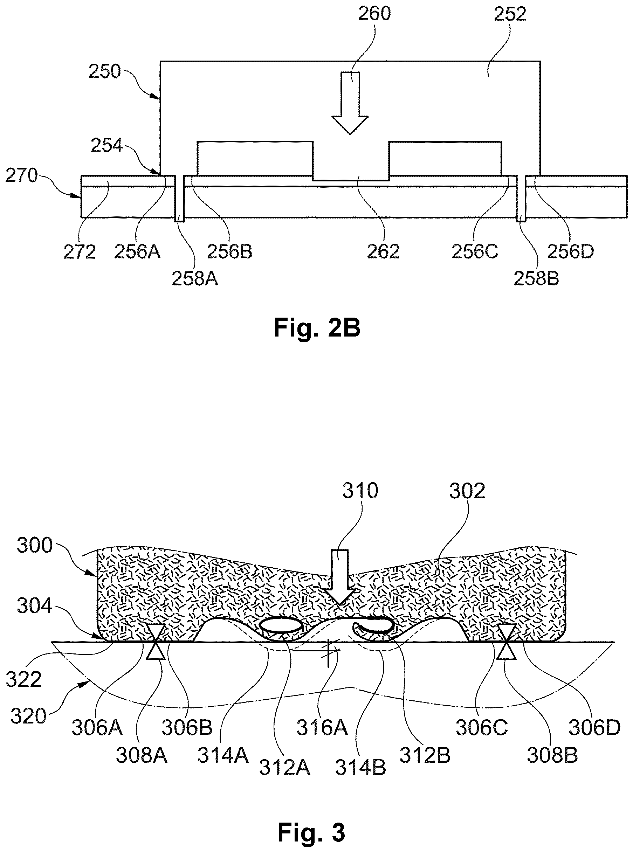

Fig. 1 shows - schematically - an EMC shield 100 according to an embodiment of the present disclosure. The EMC shield 100 comprises a wall 102. The wall 102 comprises an interface portion 104 indicated by a dashed line. The interface portion 104 comprises (is defined by) a plurality of coplanar edges 106A, 106B, 106C and 106D. The EMC shield 100 further comprises a plurality of mounting means 108A and 108B adapted for mounting the EMC shield 100 to a PCB (not shown in Fig. 1 but explained in conjunction with Figs. 2A and 2B). The mounting means 108A and 108B are formed as pins (e.g., pins adapted for a press-fit insertion into the PCB) and, when inserted into corresponding holes in the PCB, ensure that the interface portion 104 is substantially parallel (e.g., parallel within tolerances typically appliable in the art) to the PCB. The mounting direction of the EMC shield 100 to the PCB is indicated by an arrow 110.

The EMC shield 100 comprises furthermore a contact means 112 which is integrated with (e.g., formed within, formed as a part, or the like) the wall 102. The contact means 112 extends outwards the interface portion 104 along the mounting direction indicated by the arrow 110. The contact means 112 is formed such that a contact pressure between the contact means 112 and the PCB (not shown) is provided along the mounting direction indicated by the arrow 110 when the EMC shield 100 is mounted to the PCB. In some aspects of the present disclosure, the contact pressure is designed to suffice (i.e., to be high enough) to provide a gastight contact between the contact means 112 and a top metal layer of the PCB. For example, the gastight contact may be achieved by a cold weld obtained between the contact means 112 and the top metal layer of the PCB.

In some aspects of the present disclosure, the contact means 112 may be resilient and hence may be formed to be compressed under the contact pressure. This aspect is further explained in conjunction with Figs. 2A and 3 below. In other aspects of the present disclosure, the contact means 112 may be substantially non-resilient and hence may stay substantially not compressed under the contact pressure. This aspect is further explained in conjunction with Fig. 2B.

Fig. 2A shows - schematically - an EMC shield 200 according to an embodiment of the present disclosure. The EMC shield 200 comprises a wall 202, an interface portion 204, edges 206A, 206B, 206C and 206D, and mounting means 208A and 208B which correspond to analogous elements explained in conjunction with Fig. 1 above. In addition, Fig. 2A shows a PCB 220 having a top metal layer 222. The PCB 220 comprises holes (with no separate reference sign assigned) into which the mounting means 208A and 208B are inserted. Analogously as in Fig. 1, the mounting direction of the EMC shield 200 to the PCB 220 is indicated by an arrow 210. As shown in Fig. 2A, the interface portion 204 of the EMC shield 200 is located on an upper edge of the PCB 220 (which is illustrated by the interface portion 204 and the upper edge being overlayed). However, in some aspects of the present disclosure, the interface portion 204 may be located at a certain distance from the upper edge of the PCB 220, for example, due to a filling material (not shown) located between the interface portion 204 and the upper edge of the PCB 220.

The EMC shield 200 comprises furthermore a contact means 212 which is integrated with the wall 202. The contact means 212 is resilient and may, in some aspects of the present disclosure, be formed as a single ended contact beam (which is explained in conjunction with Fig. 3), a double ended contact bow, an eye-of-the-needle shape (which is explained in conjunction with Fig. 3), an H-shape/bow-tie shape, a bend castellation which may comprise a material reduction at an inside bend radius, or the like. The shape of the contact means 212 prior to mounting the EMC shield 200 to the PCB 220 (i.e., in not compressed state) is schematically indicated by a dashed line 214.

Upon mounting the EMC shield 200 to the PCB 220, a contact pressure is provided between the contact means 212 and the PCB 220 along the mounting direction indicated by the arrow 210. The contact pressure acting upon the contact means 212 effectuates compression of the resilient contact means 212 such that the contact means 212 assumes a shape not cutting into the PCB 220. In other words, the part of the EMC shield 200 which is designated by a shaded area in Fig. 2A is displaced due to compression (deformation) under the contact pressure acting upon the contact means 212. Positioning the contact means 212 nearby the top metal layer 222 (or, in some aspects of the present disclosure, providing a direct electrical contact between the contact means 212) enhances EMC/EMI properties of the EMC shield 200 by reducing a gap size in the shielding between successive contact and/or mounting means.

Fig. 2B shows - schematically - an EMC shield 250 according to an embodiment of the present disclosure. The EMC shield 250 comprises a wall 252, an interface portion 254, edges 256A, 256B, 256C and 256D, and mounting means 258A and 258B which correspond to analogous elements explained in conjunction with Fig. 1 above. In addition, Fig. 2B shows a PCB 270 having a top metal layer 272. The PCB 270 comprises holes (with no separate reference sign assigned) into which the mounting means 258A and 258B are inserted. Analogously as in Fig. 1, the mounting direction of the EMC shield 250 to the PCB 270 is indicated by an arrow 260. Furthermore, analogously as in Fig. 2A, the interface portion 254 of the EMC shield 250 is located on an upper edge of the PCB 270 (which is illustrated by the interface portion 254 and the upper edge being overlayed). However, as explained in conjunction with Fig. 2A, in some aspects of the present disclosure, the interface portion 254 may be located at a certain distance from the upper edge of the PCB 270, for example, due to a filling material (not shown) located between the interface portion and the upper edge of the PCB 270.

The EMC shield 250 comprises furthermore a contact means 262 which is integrated with the wall 252. The contact means 262 is non-resilient and may, in some aspects of the present disclosure, be formed as a sharp castellation, a curved castellation, a rounded castellation, a flat area, a coined area, or the like.

Upon mounting the EMC shield 250 to the PCB 270, a contact pressure is provided between the contact means 262 and the PCB 270 along the mounting direction indicated by the arrow 260. The contact pressure acting upon the contact means 262 effectuates substantially no compression of the non-resilient means 262 such that the non-resilient means 262 cuts into the top metal layer 272 of the PCB 270 and thereby provides a direct electrical contact between the contact means 262 and the top metal layer 272. Although limited, the PCB will hereby bow out elastically by which tolerances can be absorbed. Providing the direct electrical contact between the contact means 262 and the top metal layer 272 enhances EMC/EMI properties of the EMC shield 250 by reducing a gap size in the shielding between successive contact and/or mounting means.

Fig. 3 shows - in a two-dimensional view - a portion of an EMC shield 300 according to an embodiment of the present disclosure. The EMC shield 300 comprises a wall 302, an interface portion 304, edges 306A, 306B, 306C and 306D, and mounting means 308A and 308B (represented symbolically) which correspond to analogous elements explained in conjunction with Fig. 1 above. In addition, Fig. 3 shows a portion of a PCB 320 having a top metal layer 322. Analogously as in Fig. 1, the mounting direction of the EMC shield 300 to the PCB 320 is indicated by an arrow 310.

The EMC shield 300 comprises furthermore contact means 312A and 312B which are integrated with the wall 302. The contact means 312A is resilient and is formed as an eye-of-the-needle shape. The shape of the contact means 312A prior to mounting the EMC shield 300 to the PCB 320 (i.e., in not compressed state) is indicated by a line 314A. The amount of compression of the contact means 312A upon the mounting of the EMC shield 300 into the PCB 320 is indicated by a distance 316A. The contact means 312B is resilient and is formed as a single ended contact beam. The shape of the contact means 312B prior to mounting the EMC shield 300 to the PCB 320 (i.e., in not compressed state) is indicated by a line 314B.

Upon mounting the EMC shield 300 to the PCB 320, a contact pressure is provided between the respective contact means 312A and 312B and the PCB 320 along the mounting direction indicated by the arrow 310. The contact pressure acting upon the contact means 312A effectuates compression (deformation) of the eye-of-the-needle shape of the contact means 312A such that the contact means 312A assumes a shape not cutting into the PCB 320. Analogously the contact pressure acting upon the contact means 312B effectuates compression (deformation) of the single ended contact beam of the contact means 312B such that the contact means 312B assumes a shape not cutting into the PCB 320. Selection of a shape of a contact means generally involves various considerations including the amount of a holding (retention) force provided by mounting means (e.g., the mounting means 308A and 308B), the size of an allowable gap for EMC/EMI purposes, the degree of resilience attributable to the shape and/or technological aspects of manufacturing the shape, for example, by stamping.

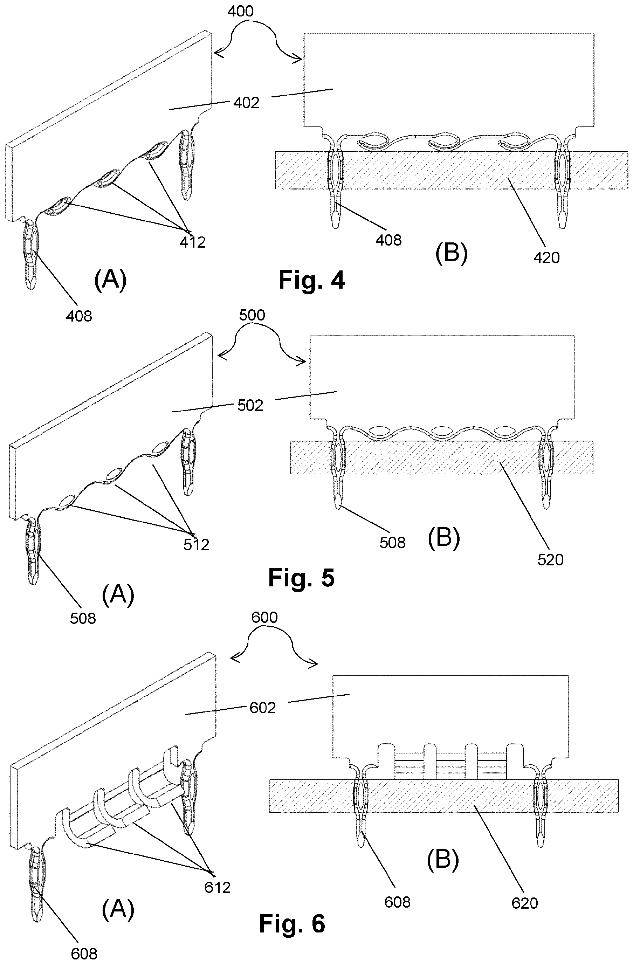

Figures 4 to 7 show four examples of possible embodiments for EMC shields, each shield having identical configuration expect for the contact means, which are different for each embodiment.

Fig. 4A shows another embodiment of an EMC shield 400 in a three-dimensional view and Fig. 4B shows the same shield 400 in a front view assembled to a PCB 420. The shield 400 comprises two contact means 408 in the form of press-fit pins adapted to be press-fitted into openings of the PCB 420. Such press-fit pins are in connection with PCBs are well known to the skilled person, so it is refrained from giving a detailed explanation thereof. The shield 400 further comprises three contact means 412 that comprise resilient means, in the form of a spiral alike contact beam.

Figures 5A and 5B show another embodiment of an EMC shield 500, comprising two mounting means 508, three contact means 512 and a wall 502. As with the other embodiments of Figures 4, 6 and 7, the EMC shield 500, the mounting means 508 and the contact means 512 are integrally formed from a single piece of sheet metal. The contact means 512 comprise an eye-of-the-needle shape, which gives the contact means 512 resilient properties.

Figures 6A and 6B show yet another embodiment of an EMC shield 600, comprising two mounting means 608, three contact means 612 and a wall 602. Each contact means 612 is realized in form of a bend castellation.

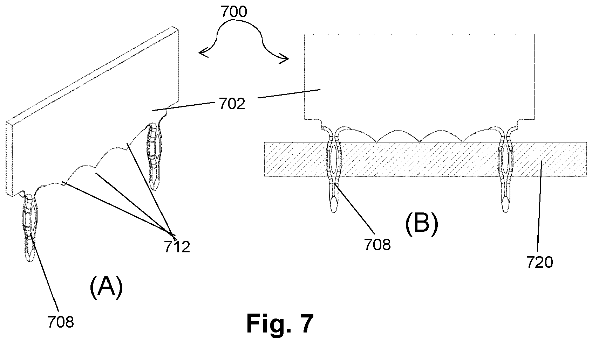

Figures 7A and 7B show yet another embodiment of an EMC shield 700, comprising two mounting means 708, three contact means 712 and a wall 702. Each contact means 712 is realized in form of a sharp castellation. In this embodiment, the contact means comprises a non-resilient means.

### List of reference signs:

- 100: EMC shield
- 102: wall
- 104: interface portion
- 106A, 106B, 106C, 106D: coplanar edges
- 108A, 108B: mounting means
- 110: mounting direction
- 112: contact means
- 200: EMC shield
- 202: wall
- 204: interface portion
- 206A, 206B, 206C, 206D: coplanar edges
- 208A, 208B: mounting means
- 210: mounting direction
- 212: contact means
- 214: shape of contact means
- 220: PCB
- 222: top metal layer
- 250: EMC shield
- 252: wall
- 254: interface portion
- 256A, 256B, 256C, 256D: coplanar edges
- 258A, 258B: mounting means
- 260: mounting direction
- 262: contact means
- 270: PCB
- 272: top metal layer
- 300: EMC shield
- 302: wall
- 304: interface portion
- 306A, 306B, 306C, 306D: coplanar edges
- 308A, 308B: mounting means
- 310: mounting direction
- 312A, 312B: contact means
- 314A, 314B: shape of contact means
- 316A: compression distance
- 320: PCB
- 322: top metal layer
- 400, 500, 600, 700: EMC shield
- 402, 502, 602, 702: wall
- 408, 508, 608, 708: mounting means
- 412, 512, 612, 712: contact means
- 420, 520, 620, 720: PCB

## Claims

1. An EMC shield (100; 200; 250; 300; 400; 500; 600; 700) for providing electromagnetic compatibility of electronic components, the EMC shield comprising:
a. at least one wall (102; 202; 252; 302; 402; 502; 602; 702) comprising an interface portion (104; 204; 254; 304), the interface portion comprising at least one coplanar edge (106A-D; 206A-D; 256A-D; 306A-D) of the wall; and
b. at least one mounting means (108A-B; 208A-B; 258A-B; 308A-B; 408; 508; 608; 708) adapted for mounting the EMC shield to a printed circuit board (220; 270; 320; 420; 520; 620; 720), PCB, such that, when the EMC shield is mounted to the PCB, the interface portion is substantially parallel to the PCB;
**characterized in that**
c. the EMC shield (100; 200; 250; 300; 400; 500; 600; 700) further comprises at least one contact means (112; 212; 262; 312A-B; 314A-B; 412; 512; 612; 712) different from the mounting mean(s), the contact mean(s) being integrated with the wall and at least partially extending outwards the interface portion (104; 204; 254; 304) in a mounting direction of the EMC shield to the PCB, the contact means being adapted for providing, when the EMC shield is mounted to the PCB, a contact pressure between the contact means and the PCB along the mounting direction.

2. The EMC shield (100; 200; 250; 300; 400; 500; 600; 700) of claim 1, wherein the contact pressure suffices to provide a gastight contact between the contact means and a top metal layer of the PCB, and preferably wherein the gastight contact is achieved by a cold weld between the contact means and the top metal layer of the PCB.

3. The EMC shield (100; 200; 250; 300; 400; 500; 600; 700) of any one of the preceding claims, wherein the contact means comprises a resilient means.

4. The EMC shield (100; 200; 250; 300; 400; 500; 600; 700) of claim 3, wherein the resilient means comprises at least one of a spiral alike contact beam, a single ended contact beam, a double ended contact bow, an eye-of-the-needle shape, an H-shape/bow-tie shape or a bend castellation, and preferably wherein the bend castellation comprises a material reduction at an inside bend radius.

5. The EMC shield (100; 200; 250; 300; 400; 500; 600; 700) of any one of the preceding claims, wherein the contact means comprises a non-resilient means.

6. The EMC shield (100; 200; 250; 300; 400; 500; 600; 700) of claim 5, wherein the non-resilient means comprises at least one of a sharp castellation, a curved castellation, a rounded castellation, a flat area or a coined area.

7. The EMC shield (100; 200; 250; 300; 400; 500; 600; 700) of any one of the preceding claims, wherein the contact means comprises at least two contact means comprising one or more resilient means and/or one or more non-resilient means.

8. The EMC shield (100; 200; 250; 300; 400; 500; 600; 700) of any one of the preceding claims, wherein the wall and the contact means are formed from a single sheet metal.

9. The EMC shield (100; 200; 250; 300; 400; 500; 600; 700) of claim 8, wherein the wall and the contact means have substantially a same thickness or wherein the contact means have a different wall thickness, preferably thinner, than the wall.

10. The EMC shield (100; 200; 250; 300; 400; 500; 600; 700) of claim 8 or 9, wherein the contact means comprises a formed section, wherein the contact means is located behind an overlapping section of the wall, or wherein the contact means is located behind an insulator and/or a housing.

11. The EMC shield (100; 200; 250; 300; 400; 500; 600; 700) of any one of the preceding claims, wherein each of the plurality of mounting means is adapted for a press-fit insertion into the PCB.

12. The EMC shield (100; 200; 250; 300; 400; 500; 600; 700) of any one of the preceding claims, wherein the contact means provides EMC functionality to the electrical connector system.

13. An electrical connector system comprising:
a housing;
a plurality of electrical contact elements arranged in the housing;
the EMC shield (100; 200; 250; 300; 400; 500; 600; 700) of any one of the preceding claims connected to the housing;
wherein the electrical connector system preferably further comprises a second EMC shield, wherein the EMC shield is connected onto the second EMC shield.

14. The electrical connector system of claim 13, wherein the second EMC shield is made of a sheet metal, a die-cast, a sintered metal, a metal injection molding, a 3D-printing, a metalized plastic, or a conductive plastic.

15. The electrical connector system of claim 13, wherein the EMC shield (100; 200; 250; 300; 400; 500; 600; 700) is connected onto the second EMC shield by riveting, laser-welding, resistance welding, ultrasonic welding, soldering or gluing.
